# EUROPÄISCHE PATENTSCHRIFT

(11) **EP 0 691 041 B1**
(45) Veröffentlichungstag und Bekanntmachung des Hinweises auf die Patenterteilung: **23.04.1997**
(21) Anmeldenummer: 94906831.6
(22) Anmeldetag: 04.02.1994
(51) Int. Cl.: G06F 13/40, H01P 3/08, H05K 9/00, H01R 13/66, H01R 23/68

(54) **ASYMMETRISCHER WELLENLEITER**
ASYMMETRICAL WAVEGUIDE
GUIDE D'ONDES ASYMETRIQUE

(30) Priorität: 22.03.1993 DE 4309147
(43) Veröffentlichungstag der Anmeldung: 10.01.1996
(73) Patentinhaber: Siemens Nixdorf Informationssysteme AG, 33106 Paderborn (DE)
(72) Erfinder: POLLMEIER, Werner, D-33415 Verl (DE)
(74) Vertreter: Fuchs, Franz-Josef, Dr.-Ing.
(86) Internationale Anmeldenummer: DE9400109
(87) Internationale Veröffentlichungsnummer: WO9422184

(56) Entgegenhaltungen:
- EP-A- 0 414 546
- DE-A- 3 838 486

## Beschreibung

### Technisches Gebiet

Es handelt sich um Signalübertragung von digitalen Signalen bei Rechenanlagen mit schneller Kommunikation über eine mehreren Baugruppen gemeinsame Rückwand.

### Stand der Technik

Rechenanlagen werden in der Regel aus Baugruppen aufgebaut, die miteinander Daten austauschen. Diese Baugruppen sind steckbar auf einer Trägerplatte angeordnet und die Kontakte der verschiedenen Steckverbinder jeweils untereinander verbunden. Damit entsteht eine Vielzahl von parallelen Leitungen, über die jeweils entsprechend viele Daten mit einer Übertragungsoperation übertragen werden können. Neben diesen Datenleitungen sind Steuerleitungen, Masseleitungen und Stromversorgungsleitungen vorhanden.

Zur Übertragung wird häufig eine asymmetrische Ansteuerung verwendet, bei der eine Datenleitung pro logischem Signal verwendet und in Bezug auf eine gemeinsame Masse geschaltet wird. Es werden insbesondere elektronische Schalter verwendet, die ein auf der Datenleitung bereitgestelltes Potential gegen eine Masseleitung verbinden. Dabei kommt es wegen der Induktivitäten und Kapazitäten auf den Signalleitungen beim Ein- oder Ausschalten zu langsamen Flanken oder auch Schwingungen. Dieser Effekt kann vermieden werden, wenn die Signalleitungen mit ihrem Wellenwiderstand abgeschlossen werden. Für Systeme geringer Geschwindigkeit wird dabei ein gemeinsamer Steckkontakt für die Masseverbindung von vielen Signalleitungen verwendet. Da hierbei über den oder die wenigen Massekontakte erheblich höhere hochfrequente Ströme fließen als über die vielen Signalkontakte, kommt es zu Störungen. Eine bekannte Maßnahme in Hochgeschwindigkeitsanwendungen ist daher die Verwendung eines Massekontakts pro Signalkontakt. Diese Lösung scheidet aus, wenn aus Kompatibilitätsgründen eine standardisierte Kontaktbelegung verwendet werden muß, bei der die Anzahl der Massekontakte festgelegt ist.

In der Veröffentlichung DE 38 38 486 A1 wird ein Verfahren zur Herstellung von Schaltungsträgern angegeben, bei denen Signalleitungen zwischen geerdeten Abschirmungen liegen.

In der Veröffentlichung EP 0 414 546 A2 wird eine Rückwand angegeben, bei der Signalleitungen zwischen Lagen für Signalmasse und Spannungsversorgung angeordnet sind.

Es ist Aufgabe der Erfindung, Moduln an einer Rückwand so zu betreiben, daß trotz eines asymmetrischen Betriebs und einer von der Anzahl von Signalkontakten unterschiedlichen Anzahl von Signalmassekontakten eine hohe Signalgeschwindigkeit möglich ist.

### Darstellung der Erfindung

Die Erfindung beruht auf der Überlegung, daß zusätzlich zu den hochfrequenzmäßig überlasteten Steckkontakten für die Signalmasse eine erhebliche Anzahl von Steckkontakten für die Stromversorgung vorhanden ist, diese hochfrequenzmäßig nicht belastet sind und deshalb für eine Entlastung der Kontakte für Signalmasse dienen können.

Eine erste Lösung besteht darin, über Kondensatoren die Kontakte der Spannungszuführung als zusätzlichen hochfrequenten Pfad zu nutzen. Dazu muß durch Kondensatoren eine hochfrequente Verbindung von der Spannungszuführung zur Signalmasse gleichermaßen auf dem Modul und der Rückwand geschaffen werden. Dies erfordert eine Anzahl von Kondensatoren, die gleich dem Produkt aus Anzahl der Steckplätze und Anzahl der Stromzuführungskontakte ist. Dabei müssen diese Kondensatoren induktionsarm mit den Steckkontakten verbunden werden, also unmittelbar daneben angebracht werden.

Durch umfangreiche Versuche konnte eine verbesserte Lösung gefunden werden, bei der auf der Rückwand keine Kondensatoren notwendig sind. Dazu muß die Spannungszuführung auf der Rückwand hochfrequenzmäßig äquivalent zu der Signalmasse ausgeführt werden. Dies kann erreicht werden, wenn die Signalleitungen in Bezug zu der Signalmasse dieselbe Wellenimpedanz haben wie in Bezug zu der Spannungszuführung. Hierzu konnten zwei Ausführungsformen ermittelt werden. Bei einer ersten Ausführungsform erhalten die Leiterbahnen bei einer Mehrlagen-Leiterplatte für Signalmasse und Spannungszuführung das gleiche Layout und liegen in benachbarten Ebenen. Dabei werden die Spannungszuführung in eine äußere und die Signalmasse in die unmittelbar benachbarte Ebene gelegt und eine Isolierschicht möglichst geringer Dicke verwendet. Die Signalleitungen werden auf der gegenüberliegenden Außenlage geführt und durch eine erheblich dicker ausgeführte Isolierschicht (gleichen Materials) von den o.g. Ebenen getrennt. Damit ist der Abstand von den Signalleitungen zur Signalmasse und von den Signalleitungen zur Spannungszuführung im wesentlichen gleich, so daß die Wellenleiterimpedanz gegenüber beiden sich nicht wesentlich unterscheidet. Eine kapazitive Verbindung zwischen Signalmasse und Spannungszuführung ist nur noch an den Enden notwendig, wo auch die Abschlußwiderstände für die Signal-Wellenleiter angeordnet sind.

Bei einer dritten Ausführungsform können die Signalleitungen in eine Mittellage gelegt und Signalmasse und Spannungszuführung in den beiden Aussenlagen geführt werden. Diese Lösung wird verwendet, wenn die Isolierschicht zwischen Signalleiter und Signalmasse schon recht dünn ist und eine wesentlich dünnere Schicht zwischen Signalmasse und Spannungszuführung nicht mehr gefertigt werden kann.

Die Erfindung sorgt daher dafür, daß auch die Stromzuführung in die Wellenleitung der Signalleitungen einbezogen wird. Damit sind dann die Kondensatoren an den Steckkontakten auf der Rückwand entbehrlich; der gewünschte Effekt wird durch das Layout der als gedruckte Schaltung realisierten Rückwand erreicht.

Die Erfindung kann vorteilhaft auch auf einem Modul selbst angewendet werden. Beispielsweise sind die elektronischen Schalter entfernt von den Verbinderkontakten angeordnet. Die Signalleitungen, die Signalmasse und die Versorgungsspannung werden wie auf der Rückwand mit gleichem Wellenwiderstand zwischen Signalleitung und Signalmasse sowie zwischen Signalleitung und Versorgungsspannung geführt. Dann ist unmittelbar am Schalter eine wechselstrommäßige Kopplung einzurichten, also inbesondere ein induktivitätsarmer Kondensator zwischen Signalmasse und Versorgungsspannung zu schalten. Ein solcher Kondensator ist üblicherweise bereits vorhanden, um die Versorgungsspannung abzupuffern. Damit sind keine zusätzlichen Kondensatoren mehr notwendig, weil die Beschleunigung der Signalübertragung allein durch die geschickte Anordnung der Leiterbahnen erreicht wird.

Die Erfindung besteht also darin, daß in einem System mit Moduln, Spannungsversorgung, Signalübertragung über abgeschlossene Signalleitungen und Signalmasse die Impedanz der Signalleitungen gegenüber sowohl der Signalmasse als auch der Spannungsversorung gleich ist, wobei eine wecheselstrommäßige Kopplung der Kontakte für Signalmasse und Spannungszuführung auf den Moduln und nahe dem Abschluß der Signalleitungen erfolgt.

### Kurzbeschreibung der Zeichnungen

Es zeigen
- Fig. 1: eine vereinfachte Ansicht auf die Rückwand eines Rechners,
- Fig. 2: ein Schaltbild für die Verschaltung der Moduln und der Rückwand,
- Fig. 3: einen Querschnitt durch die Rückwand mit außenliegenenden Signalleitungen und
- Fig. 4: einen Querschnitt durch die Rückwand mit innenliegenden Signalleitungen.

### Detaillierte Beschreibung der Erfindung

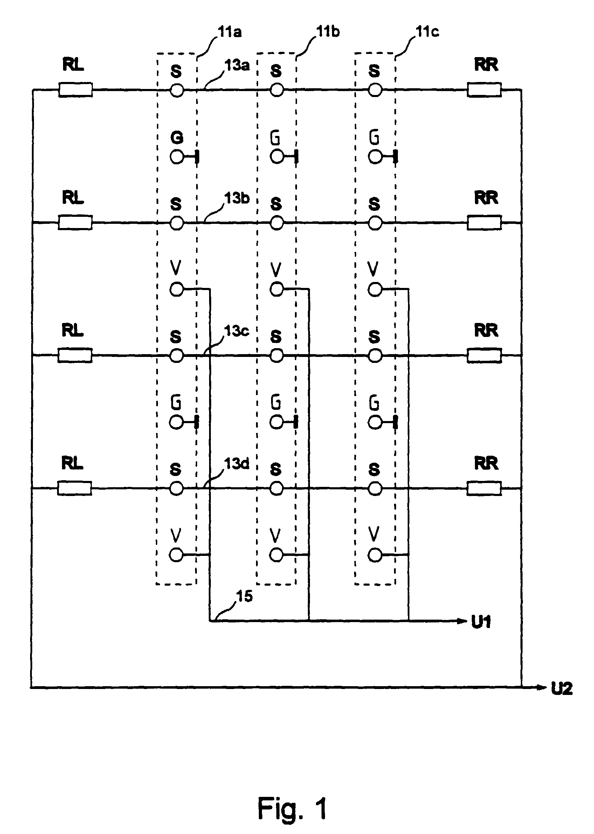

In Fig. 1 ist eine Rückwand 10 dargestellt, die zur besseren Übersicht mit nur drei Steckleisten 11a..c und neun Kontakten pro Steckleiste dargestellt ist. Die Pole S sind Signalkontakte, die durch Leiterbahnen 13a..e jeweils miteinander verbunden sind. Die Pole G dienen als Massepole und sind durch Masseverbindungen miteinander verbunden. Die Pole V dienen der Spannungszuführung und sind über Zuleitungen-15 mit der Betriebsspannung U1 verbunden. Die Signalleitungen 13a..e sind an beiden Enden durch Abschlußwiderstände RL und RR wellenleitermäßig abgeschlossen. Dabei sind die linken Widerstände RL und die rechten Widerstände RR einander gleich und gleich dem Wellenwiderstand der Signalleitungen 13 gegenüber der Singnalmasse 14. Dieser wird bestimmt durch die Breite der Signalleitung 13 und deren elektischem Abstand zur Signalmasse 14, der sich aus der Dielektrizitätskonstante des Leiterplattenmaterials und dem räumlichen Abstand bestimmt.

Betrieben wird diese Rückwand als ein Bussystem mit Open-Kollektor-Struktur, bei dem ein LOW-Bit durch Verbindung einer Signalleitung mit Masse und ein High-Bit durch Unterlassen dieser Verbindung signalisiert wird. Zu diesem Zweck wird der Abschlußwiderstand gleichspannungsmäßig auf ein Potential U2 gelegt.

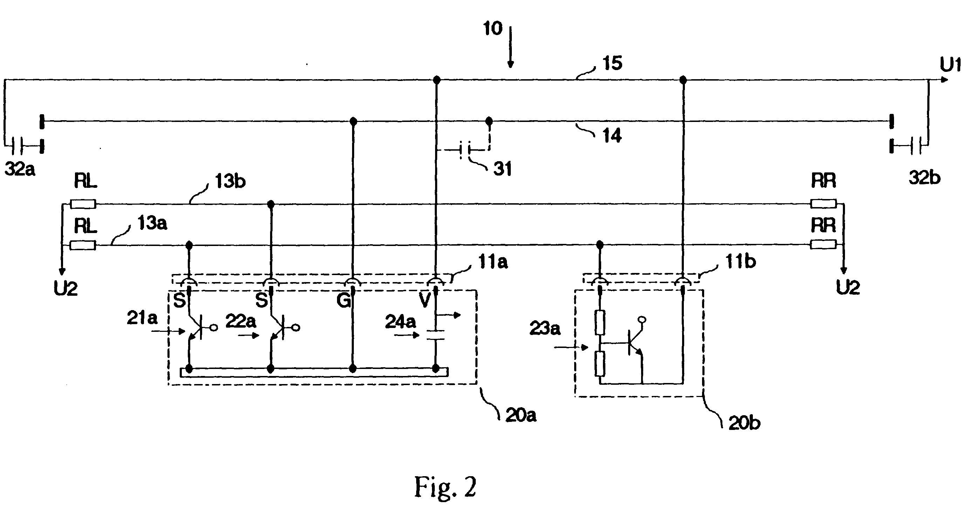

Diese Situation ist in Fig. 2 in ihrer elektrischen Wirkung dargestellt. Auf der Rückwand befinden sich die Teile außerhalb der gestrichelt umrahmten Moduln 20a und 20b. Mit 11a und 11b sind die auf der Rückwand befestigten Steckverbinder und mit 20a und 20b die damit kontaktierten Moduln bezeichnet. Im Beispiel der Fig.2 ist 20a ein sendender Modul und 20b ein empfangender Modul. Die dargestellten Sende- und Empfangsmittel sind auf allen Moduln für alle Signalleitungen vorhanden; dies ist zu Gunsten der Übersichtlichkeit vereinfacht.

In dem sendenden Modul 20a ist ein Halbleiterschalter 21a angeordnet, der mit einem Signalkontakt S und einer Signalmasse 22a verbunden ist. Der Signalkontakt S ist, wie bereits beschrieben, über die Leitung 13a mit den beiden Abschlußwiderständen RL und RR verbunden, die ihrerseits an die Spannung U2 angeschlossen sind. Ist der Halbleiterschalter 21a nicht aktiv, so liegt die Leitung 13a auf dem Potential U2. Ist der Halbleiterschalter 21a hingegen aktiv, so fließt der durch Pfeile angedeutete, durch die Widerstände RL und RR bestimmte Strom von der Spannungsquelle U2 durch die Widerstände RL bzw. RR, über die Signalleitung 13a, durch den Kontakt S, durch den Halbleiterschalter 21a, längs der Masseleitung 22a im Modul 20a, durch den Kontakt G und die Masseleitung 14 zurück in die Spannungsquelle U2. Dabei entsteht auf der Leitung 13a ein Potential nahe Masse, das von dem empfangenden Modul 20b mit einer Empfangsschaltung 23a ausgewertet wird.

Sind mehrere Schalter 21 gleichzeitig geschaltet, so fließt die Summe der Ströme, die durch die Kontakte S fließen, durch den gemeinsamen Kontakt G. Der Gleichstrom-Kontaktwiderstand ist dabei so gering, daß kein wesentlicher Spannungsabfall entsteht.

Anders liegen die Verhältnisse im Zeitpunkt des Schaltens. Hierbei ist die Induktivität der Kontaktstifte ausschlaggebend. Bei besonders schnellen Schaltern 21 entsteht über die Induktivität der Kontakte ein Einschwingvorgang, der die Maximalgeschwindigkeit der Busbenutzung begrenzt.

Die Kontakte zur Spannungszuführung werdem wechselstrommäßig mitbenutzt, so daß sich die Induktivitäten der Kontaktstifte durch Parallelschaltung verringern. Hierzu wird auf jedem Modul und an jedem Spannungszuführungs-Kontakt V ein Kondensator 24 zwischen diesem und Signalmasse angebracht. Auf Seite der Rückwand ist nun der Kontakt V gleichfalls wechselstrommäßig mit der Signalmasse verbunden. Hierzu bei jedem Kontakt V ein Kondensator 31 angebracht.

Eine wesentliche Verbesserung, bei der auf den Kondensator 31 verzichtet werden kann, wird dadurch erreicht, daß der Wellenwiderstand der Signalleitung 13 in Bezug zur Signalmasse 14 gleich dem Wellenwiderstand derselben Signalleitung 13 in Bezug zur Spannungszuführung 15 gestaltet wird. Dies wird bei Verwendung einer Leiterplatte dadurch erreicht, daß das Layout von Signalmasse 14 und Spannungszuführung 15 im wesentlichen gleich gestaltet wird, und beide etwa gleichen elektrischen Abstand zur Signalleitung 13 haben.

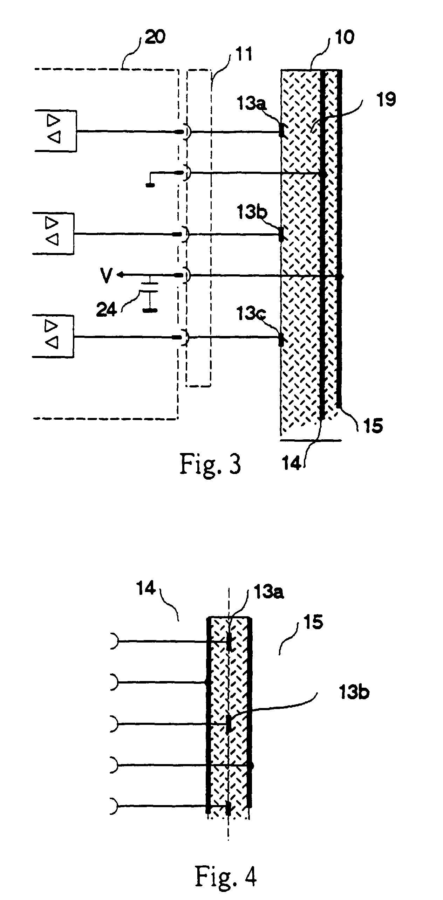

Dies wird nach Fig. 3 und 4 dadurch erreicht, daß eine Leiterplatte mit drei Lagen benutzt wird. Nach Fig. 3 werden die Signalleitungen auf der linken Außenlage geführt. Die rechte Außenlage wird für die Spannungszuführung 15 benutzt. Unmittelbar daneben befindet sich die Signalmasse 14, wobei zwischen Spannungszuführung 15 und Signalmasse 14 ein erheblich geringerer Abstand ist, beispielsweise 0.1mm, als zwischen den Signalleitungen 13 und der Signalmasse 14, beispielsweise 0.5mm. Signalmasse 14 und Spannungszuführung 15 haben aus Sicht der Signalleitungen 13 überwiegend das gleiche Layout. Damit sind sie in Bezug auf die Wellenleitung einander äquivalent, und es genügt der Kondensator 24 zur Ankopplung des Kontaktes V an die Signalmasse auf dem Modul 20. In Fig. 4 ist eine alternative Ausführungsform dargestellt, bei der die Signalleitungen in der Mitte angeordnet sind. Diese Form ist vorteilhaft, wenn ein kleiner Wellenwiderstand angestrebt wird und daher der Abstand von den Signalleitern 13 zur Signalmasse der geringste herstellbare ist. Außerdem wird in dieser Ausführung die Störstrahlung der Signalleitungen abgeschirmt.

Die Erfindung kann vorteilhaft auch auf einem Modul 20 angewendet werden, wenn die elektronischen Schalter 21 entfernt von den Steckkontakten angeordnet sind. Die Signalleitungen 13, die Signalmasse 14 und die Versorgungsspannung 15 werden wie auf der Rückwand 20 mit gleichem Wellenwiderstand zwischen Signalleitung 13 und Signalmasse 14 sowie zwischen Signalleitung 13 und Versorgungsspannung 15 geführt. Die wechselstrommäßige Kopplung auf dem Modul wird durch einen bereits vorhandenen Abblockkondensator erreicht, so daß der Kondensator 24a nahe den Kontakten entfallen kann.

Es hat sich als zusätzlich vorteilhaft herausgestellt, auf dem Modul zwischen Massekontakten und Versorgungskontakten eine Dämpfung anzubringen. Diese erfolgt vorzugsweise durch einen Kondensator geringer Güte, der, falls hier die Kondensatoren zur Verbindung zwischen Signalmasse und Versorgungsspannung angeordnet sind, diesen parallel geschaltet ist.

Die Erfindung kann auch bei Verbindern verwendet werden, die nicht als betriebsmäßig lösbare Stecker ausgebildet sind, sondern auch beispielsweise bei Moduln, die über Kontakte auf einer gemeinsamen Trägerplatte verlötet werden.

## Patentansprüche

1. Anordnung zur Signalübertragung zwischen Moduln, die über Verbinder an einer gemeinsamen Rückwand angeschlossen sind, mit den Merkmalen:
- die Signalübertragung erfolgt durch Signalleitungen (13a, 13b) mit einer gemeinsamen Signalmasse (14);
- die Signalleitungen (13a, 13b) sind auf der Rückwand (10) als Wellenleiter ausgeführt, deren Wellenwiderstand gegenüber der Signalmasse (14) gleich dem Wellenwiderstand gegenüber einer Spannungsversorgung (15) ist;
gekennzeichnet dadurch, daß
- die Signalleitungen (13a, 13b) auf der Rückwand (10) an ihren Enden durch Widerstände (RL, RR) gegenüber Signalmasse (14) abgeschlossen sind;
- die Verbinder (11a, 11b) zwischen den Moduln (24a, 24b) und der Rückwand (10) jeweils einen Kontakt (S) für jede Signalleitung, mindestens einen Kontakt (G) für die Signalmasse und mindestens einen Kontakt (V) für die Spannungsversorgung haben;
- die Anzahl der Kontakte (G) für Signalmasse kleiner als die Anzahl der Kontakte (S) für die Signalleitungen ist;
- auf jedem Modul Spannungsversorgung und Signalmasse nahe den Kontakten durch Kondensatoren (24a,) wechselspannungsmäßig verbunden sind,
- auf der Rückwand (10) eine durch Kondensatoren (32a, 32b) bewirkte wechselspannungsmäßige Kopplung zwischen Spannungsversorgung (15) und Signalmasse (14) ausschließlich nahe den Abschlußwiderständen (RR, RL) erfolgt.

2. Anordnung nach Anspruch 1 mit einer Rückwand aus im wesentlichen homogenem, plattenförmigem Baismaterial (19), wobei die Signalleitungen (13) nahe der einen Oberfläche des Basismaterials (19), und die Signalmasse (14) sowie die Spannungszuführung (15) nahe der anderen Oberfläche des Basismaterials (19) angeordnet sind und der Abstand zwischen Signalleitung (13) und Signalmasse (14) oder Spannungszuführung (15) mindestens doppelt so groß ist wie der zwischen Signalmasse (14) und Spannungszuführung (15).

3. Anordnung nach Anspruch 2, wobei der größere Abstand 0,5mm ±0.1mm und der kleinere 0.1mm±0.05mm beträgt.

## Claims

1. Arrangement for signal transmission between modules which are connected via connectors to a common backplane, having the features:
- the signal transmission is carried out by means of signal lines (13a, 13b) with a common signal earth (14);
- the signal lines (13a, 13b) are implemented on the backplane (10) as waveguides, whose characteristic impedance with respect to the signal earth (14) is equal to the characteristic impedance with respect to a voltage supply (15);
characterized in that
- the signal lines (13a, 13b) on the backplane (10) are terminated with respect to signal earth (14) at their ends by means of resistors (RL, RR);
- the connectors (11a, 11b) between the modules (24a, 24b) and the backplane (10) have in each case one contact (S) for each signal line, at least one contact (G) for the signal earth and at least one contact (V) for the voltage supply;
- the number of contacts (G) for signal earth is smaller than the number of contacts (S) for the signal lines;
- on each module, voltage supply and signal earth are AC coupled close to the contacts by means of a capacitor (24a),
- on the backplane (10), an AC coupling effected by means of capacitors (32a, 32b) between the voltage supply (15) and signal earth (14) is carried out exclusively close to the terminating resistors (RR, RL).

2. Arrangement according to Claim 1, having a backplane made of an essentially homogeneous base material (19) in the form of a board, the signal lines (13) being arranged close to one surface of the base material (19), and the signal earth (14) and the voltage supply (15) being arranged close to the other surface of the base material (19), and the spacing between signal line (13) and signal earth (14) or voltage supply (15) being at least twice as large as that between signal earth (14) and voltage supply (15).

3. Arrangement according to Claim 2, the greater spacing being 0.5 mm ± 0.1 mm and the smaller being 0.1 mm ± 0.05 mm.

## Revendications

1. Disposition des signaux de transmission entre des modules, qui sont connectés par l'intermédiaire de connecteurs à une paroi arrière commune, ayant les caractéristiques :
- la transmission des signaux s'effectue par des conducteurs (13a, 13b) de signaux ayant une masse (14) de signaux commune ;
- les conducteurs (13a, 13b) de signaux sont réalisés sur la paroi arrière (10) en tant que guides d'ondes, dont la résistance caractéristique par rapport à la masse (14) des signaux est la même que la résistance caractéristique par rapport à une alimentation (15) en tension ;
caractérisé en ce que
- les conducteurs (13a, 13b) de signaux sur la paroi arrière (10) se terminent aux extrémités par des résistances (RL, RR) par rapport à la masse (14) des signaux ;
- les connecteurs (11a, 11b) entre les modules (24a, 24b) et la paroi arrière (10) ont chacun un contact (S) pour chaque conducteur de signaux, au moins un contact (G) pour la masse des signaux et au moins un contact (V) pour l'alimentation en tension ;
- le nombre des contacts (G) pour la masse des signaux est plus petit que le nombre des contacts (S) pour les conducteurs de signaux ;
- l'alimentation en tension et la masse des signaux est reliée en tension alternative sur chaque module à proximité des contacts par des condensateurs (24a),
- il s'effectue sur la paroi arrière (10) un couplage en tension alternative qui est provoqué par des condensateurs (32a, 32b), entre l'alimentation (15) en tension et la masse (14) des signaux exclusivement à proximité des résistances (RR, RL) de terminaison.

2. Disposition suivant la revendication 1, comportant une paroi arrière en un matériau (19) de base en forme de plaque sensiblement homogène, les conducteurs (13) de signaux étant prévus à proximité de l'une des surfaces du matériau (19) de base et la masse (14) des signaux ainsi que l'alimentation (15) en tension étant prévues à proximité de l'autre surface du matériau (19) de base et la distance entre le conducteur (13) de signaux et la masse (14) des signaux ou l'alimentation (15) en tension étant au moins égale à deux fois la distance entre la masse (14) des signaux et l'alimentation (15) en tension.

3. Disposition suivant la revendication 2, dans lequel la plus grande distance est de 0,5 mm ± 0,1 mm et la plus petite distance est de 0,1 mm ± 0,05 mm.
